Europäisches Patentamt

European Patent Office

Office européen des brevets

(11) Veröffentlichungsnummer: **0 217 118**
**A2**

(12) **EUROPÄISCHE PATENTANMELDUNG**

(21) Anmeldenummer: 86111733.1

(22) Anmeldetag: 25.08.86

(51) Int. Cl.⁴: **G06K 9/54** , **H01L 23/54**

(30) Priorität: 30.09.85 DE 3534911

(43) Veröffentlichungstag der Anmeldung:
08.04.87 Patentblatt 87/15

(84) Benannte Vertragsstaaten:
BE DE FR GB IT NL SE

(71) Anmelder: **Siemens Aktiengesellschaft Berlin
und München
Wittelsbacherplatz 2
D-8000 München 2(DE)**

(72) Erfinder: **Scherl, Wolfgang, Dipl.-Ing.
Kafkastrasse 54
D-8000 München 83(DE)**

(54) Verfahren zur automatischen Trennung von Nutz- und Störinformation in Mikroskopbildern, insbesondere von Wafer-Oberflächen, zum Zwecke einer automatischen Erkennung von Wafer Kennzeichnungen.

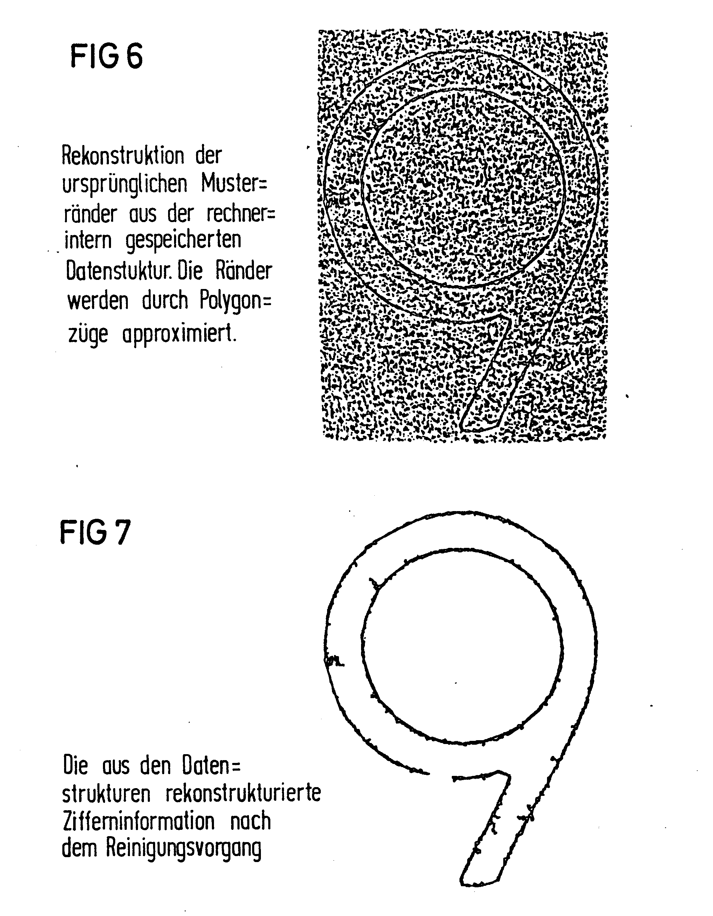

(57) Ein Verfahren zur automatischen Trennung von Nutz-und Störinformationen in Mikroskopbildern, insbesondere von Wafer-Oberflächen zum Zwecke einer automatischen Erkennung von Wafer-Kennzeichnungen, das sich in einen Bildaufbereitungsschritt, eine Umwandlung des Bildinhalts in eine Darstellung durch Datenstrukturen (Fig. 6) sowie in den eigentlichen Trennschritt zur Unterscheidung zwischen Nutz-und Störinformationen gliedert. Das Verfahren ist Voraussetzung für eine automatische Erkennung stark gestörter Wafer-Kennzeichnungen. Es erlaubt, die dünnen Kennzeichnungskonturen auf einem Wafer auch bei extremen Störungen und äußerst geringem Störabstand nahezu ungestört zu rekonstruieren.

Rekonstruktion der ursprünglichen Muster=ränder aus der rechner=intern gespeicherten Datenstuktur. Die Ränder werden durch Polygon=züge approximiert.

FIG 6

EP 0 217 118 A2

## Verfahren zur automatischen Trennung von Nutz-und Störinformation in Mikroskopbildern, insbesondere von Wafer-Oberflächen zum Zwecke einer automatischen Erkennung von Wafer-Kennzeichnungen

Die vorliegende Erfindung betrifft ein Verfahren zur automatischen Trennung von Nutz-und Störinformation in Mikroskopbildern, insbesondere von Wafer-Oberflächen zum Zwecke einer automatischen Erkennung von Wafer-Kennzeichnungen.

Zur Identifizierung eines Wafers im Fertigungsprozeß wird dieser durch Ziffern und/oder Buchstaben im Basismaterial eindeutig gekennzeichnet. Für eine weitere Automatisierung des Fertigungsprozesses wäre es von Vorteil, wenn diese von einer Maschine automatisch gelesen werden könnten. Einem Einsatz konventioneller optischer Lesergeräte steht jedoch die äußerst kontrastarme und extrem gestörte Bildinformation der Kennzeichnung entgegen. Aufgrund wechselnden Reflexionsverhaltens und der dünnen Ausprägung der Randkonturen erscheinen die Ziffern bzw. Buchstaben mit sehr geringem Signal/Störabstand und starken Störeinstreuungen. Deshalb sind gängige Verfahren der Bildverbesserung und der Mustererkennung nur mit Einschränkungen oder überhaupt nicht einzusetzen.

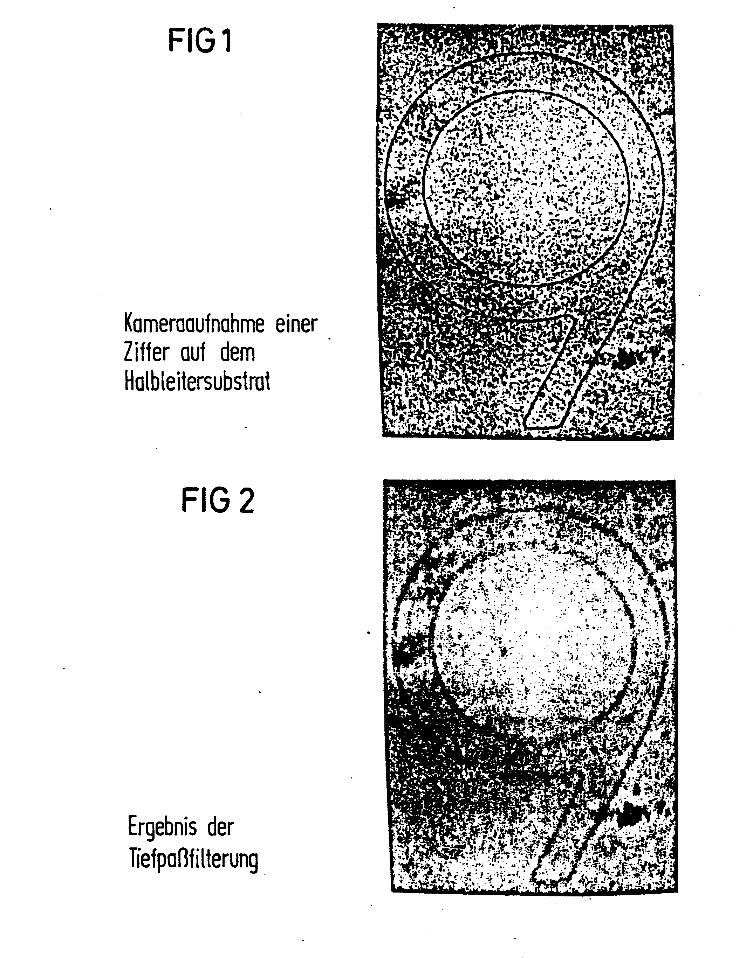

Bei den Fertigungs-und Meßprozessen fallen eine Fülle von Daten an, die dem jeweiligen Schaltkreis zugeordnet werden müssen. Soll der Wafer richtig in einem Meßautomaten positioniert werden, geschieht dies anhand der Lagekoordinaten der Schaltkreise auf dem Wafer. Problematisch ist es dagegen, bestimmte Meßwerte zwischen den einzelnen Automaten der Fertigungsstrecke weiterzureichen und dem richtigen Bauelement wieder zuzuordnen. Durch unsorgfältige Arbeitsweise des hierzu notwenigen Bedinungspersonals können beispielsweise einzelne Wafer vertauscht werden. Um trotzdem eine klare Zuordnung der Meßdaten zum Schaltkreis zu ermöglichen, wird eine eindeutige Kennzeichnung auf den Wafer aufgebracht. Diese wird bei der Herstellung des Wafers oder in einem ersten Verarbeitungsschritt (z. B. mit einem Laser) in das Substrat "eingeschnitten". Fig. 1 zeigt eine derartige Kennzeichnung als einzelne Ziffer auf einem Halbleitersubstrat.

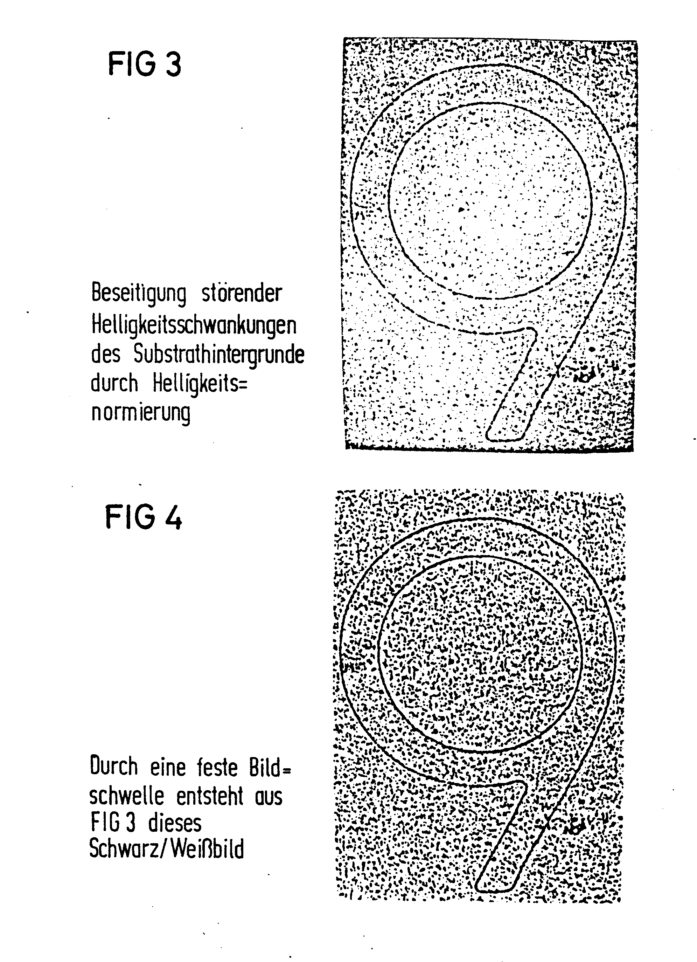

Zur Identifizierung des Wafers muß diese Kennzeichnung in jedem Gerät der Fertigungsstrecke mit hoher Sicherheit automatisch erkannt werden. Hierzu sind Verfahren der Mustererkennung und Bildverarbeitung nötig. Geräte, die auf dieser Basis Ziffern und Schriftzeichen erkennen, sind bereits als Beglesser oder Ganzseitenleser auf dem Markt. Der Einsatz dieser gängigen Mustererkennungsgeräte scheitert im vorliegenden Fall jedoch an der speziellen Art der auszuwertenden Bilder. Zum einen ist, wie in Fig. 1 gezeigt, der Kontrast zwischen Nutzinformation und Hintergrund wesentlich geringer, als dies bei Papierbelegen der Fall ist. Zum anderen werden in dem Bild nur Ziffern-bzw. Zeichenkonturen sichtbar. Eine weitere Schwierigkeit stellen die starken Helligkeitsschwankungen des Substrathintergrundes dar. Aus diesen Tatsachen ergibt sich das extrem ungünstige Verhältnis von Nutzinformation zu Störung (siehe insbesondere das Bild gemäß Fig. 4, das sich aus dem Bild gemäß Fig. 1 nach Umwandlung in ein Schwarz/Weiß-Bild ergibt). Das Trennen von Nutz-und Störinformation ist hierbei mit gängigen Vorverarbeitungsverfahren der bekannten Bild verarbeitungstechnik praktisch nicht mehr möglich.

Der vorliegenden Erfindung liegt die Aufgabe zugrunde, ein Verfahren zur automatischen Trennung von Nutz-und Störinformation in Mikroskopbildern, insbesondere von Wafer-Oberflächen zum Zwecke einer automatischen Erkennung von Wafer-Kennzeichnungen zu schaffen, mit dessen Hilfe die zuvor erläuterten Vorgänge im Fertigungsprozeß automatisch und zuverlässig abgewickelt werden können.

Die der Erfindung zugrundeliegende Aufgabe wird durch ein Verfahren der eingangs genannten Art und gemäß dem Oberbegriff des Patentanspruchs 1 gelöst, das durch die in dem kennzeichnenden Teil des Patentanspruchs 1 angegebenen Merkmale charakterisiert ist.

Vorteilhafte Weiterbildungen der Erfindung sind durch die in den Unteransprüchen angegebenen Merkmale gekennzeichnet.

Im folgenden wird die vorliegende Erfindung anhand mehrerer, das Verfahren verdeutlichender Figuren im einzelnen erläutert.

Fig. 1 zeigt ein Bild, das aufgrund einer Video-Kameraaufnahme einer Ziffer auf einem Halbleitersubstrat zustandegekommen ist.

Fig. 2 zeigt ein Bild, das das Ergebnis einer Tiefpaßfilterung des Bildes gemäß Fig. 1 darstellt.

Fig. 3 zeigt ein Bild, das nach Beseitigung störender Helligkeitsschwankungen des Substrathintergrundes durch eine sog. Helligkeitsnormierung aus einer Verknüpfung der Bilder gemäß Fig. 1 und Fig. 2 hervorgegangen ist.

Fig. 4 zeigt ein Bild, das nach Anwendung einer festen sog. Bildschwelle aus dem Bild gemäß Fig. 3 entstanden ist.

Fig. 5 zeigt schematisch ein Unterverfahren zum Bestimmen sog. Tangentialpunkte, die durch Abtastung der Ränder von Kennzeichnungssymbolen in vier Richtungen bestimmt werden.

Fig. 6 zeigt eine durch Plotter vorgenommene Rekonstruktion einer rechnerintern gespeicherten Datenstruktur für das betreffende Bild.

Fig. 7 zeigt ein Bild, das eine aus den Datenstrukturen rekonstruierte Zifferninformation nach einem sog. Reinigungsvorgang darstellt.

Wie bereits erläutert, zeigt Fig. 1 ein aufgrund einer Kameraaufnahme entstandenes Bild einer Ziffer auf einem Halbleitersubstrat. Dieses durch das Abtasten mittels einer Video-Kamera entstandene Bild wird mittels eines Tiefpaßfilters in ein kontrastarmes Bild, wie in Fig. 2 gezeigt, übergeführt. Durch eine Normierung der bestehenden Grauwerte wird gemäß der Formel

$$B3 = (B1/B2-D) \, F$$

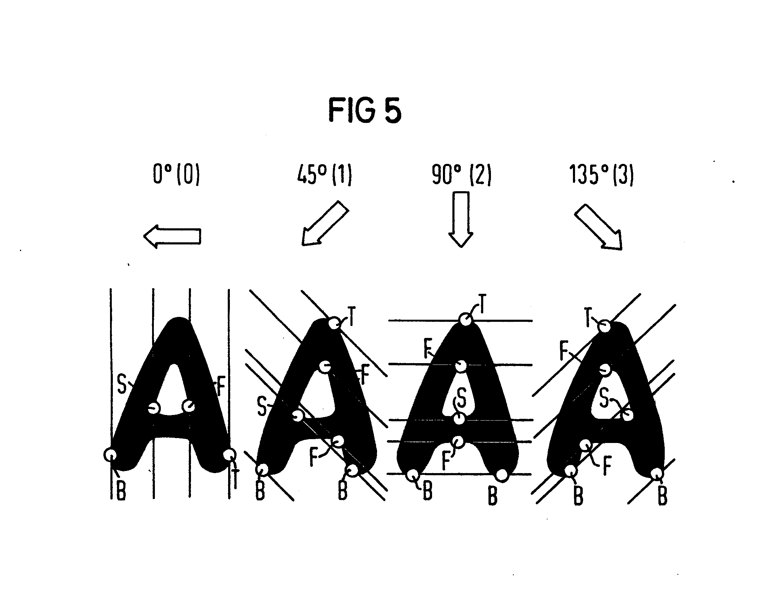

das ursprüngliche Bild (Fig. 1) in ein von störenden Helligkeitsschwankungen befreites Bild (Fig. 3) übergeführt, wobei B1, B2 und B3 einander entsprechende Bildpunkte der Bilder gemäß Fig. 1, Fig. 2 bzw. Fig. 3 und D und F Normierungskonstanten sind. Die Konstante D bewirkt, daß das Helligkeitsminimum auf den Grauwert "0" gelegt wird. Die Konstante F wird so festgelegt, daß der hellste Bildteil in B3 auf den Wert "255" zu liegen kommt (Helligkeitsnormierung). Die Ermittlung dieser beiden Kon stanten erfolgt durch einen Probelauf. Durch Bewerten der Bildpunktinformation des von Helligkeitsschwankungen befreiten Bildes (Fig. 3) wird entweder mittels einer fest vorgegebenen Bildpunkthelligkeitsschwelle oder durch eine variable Schwelle, die in an sich bekannter Weise durch eine Auswertung des Grauwerthistogramms - (aus Bild 3) gemäß Fig. 3 ermittelt wird, ein Schwarz/Weiß-Bild erstellt, vergl. Fig. 4. Die in dem Schwarz/Weiß-Bild (Fig. 4) bestehenden Ränder von Stör-und Nutzanteilen werden mittels eines Tangentialpunkt-Bestimmungsverfahrens, wie aus der DE-OS'n 32 38 706 und 32 36 336 bekannt, vergl. Fig. 5, durch das jeweils Tangentialpunkte für einen Sattel S, eine Verzweigung F, einen Basispunkt B bzw. einen Kopfpunkt T bei Abtastung der Ränder in vorzugsweise vier Richtungen, nämlich 0°, 45°, 90°, 135°, bestimmt werden, durch Polygonzüge approximiert, wozu der Bildinhalt in eine Datenstruktur umgesetzt wird, die zu Testzwecken ausgeplottet werden kann (Fig. 6). Durch einfache, vorbestimmte Abmessungskriterien werden die in der Datenstruktur, vergl. Fig. 6, noch vorhandenen Störelemente aus der durch die Datenstruktur gegebenen digitalen Bildbeschreibung eliminiert, so daß die ursprüngliche, nunmehr von Störelementen befreite Kennzeichnungsstruktur weitgehend ungestört rekonstruiert werden kann, vergl. Fig. 7. Aus der derart störungsbefreiten Kennzeichnungsbeschreibung sind notwendige Merkmale zur automatischen Kennzeichnungs-Erkennung und weitere in dem Fertigungsprozeß erforderliche Schritte abzuleiten.

Die Überführung des ursprünglichen Bildes - (Fig. 1) wird gemäß einer vorteilhaften Weiterbildung der vorliegenden Erfindung in das kontrastarme Bild gemäß Fig. 2 mittels eines Rechteckfilters der Kantenlänge 11 × 11 Bildpunkte (Pixels) durchgeführt.

Erfindungsgemäß ist außerdem vorgesehen, daß die zuvor beschriebenen Verfahrensschritte rechnergesteuert sind.

## Ansprüche

1. Verfahren zur automatischen Trennung von Nutz-und Störinformationen in Mikroskopbildern, insbesondere von Wafer-Oberflächen zum Zwecke einer automatischen Erkennung von Wafer-Kennzeichnungen, dadurch **gekennzeichnet,**

-daß ein betreffendes Mikroskopbild mittels einer Video-Kamera abgetastet wird,

-daß ein durch das Abtasten entstehendes Bild - (Fig. 1) mittels eines Tiefpaßfilters in ein kontrastarmes Bild (Fig. 2) übergeführt wird,

-daß durch eine Normierung der bestehenden Grauwerte gemäß der Formel

$$B3 = (B1/B2-D) \, F$$

das ursprüngliche Bild (Fig. 1) in ein von störenden Helligkeitsschwankungen befreites Bild (Fig. 3) übergeführt wird, wobei B1, B2 und B3 einander entsprechende Bildpunkte der Bilder gemäß Fig. 1, Fig. 2 bzw. Fig. 3 und D und F durch Testreihen festgelegte Normierungskonstanten sind,

-daß durch Bewerten der Bildpunktinformation des von Helligkeitsschwankungen befreiten Bildes (Fig. 3) mittels einer fest vorgegebenen Bildpunkthelligkeitsschwelle ein Schwarz/Weiß-Bild (Fig. 4) erstellt wird,

-daß die in dem Schwarz/Weiß-Bild (Fig. 4) bestehenden Ränder von Stör-und Nutzanteilen mittels eines Tangentialpunkt-Bestimmungverfahrens (Fig. 5), durch das jeweils Tangentialpunkte für einen Sattel (S), eine Verzweigung (F), einen Unterpunkt (B) bzw. einem Oberpunkt (T) bei Abtastung der Ränder in vorzugsweise vier Richtungen (0°, 45°, 90°, 135°) bestimmt werden, durch Polygonzüge approximiert werden, wozu der Bildinhalt in eine Datenstruktur umgesetzt wird, die zu Testzwecken ausgeplottet werden kann (Fig. 6),

-daß durch einfache, vorbestimmte Abmessungskriterien die in der Datenstruktur (vergl. Fig. 6) noch vorhandenen Störelemente aus der durch die Datenstruktur gegebenen digitalen Bildbeschreibung eliminiert werden, so daß die ursprüngliche, nunmehr von Störelementen befreite Kennzeichnungsstruktur weitgehend ungestört rekonstruiert werden kann (Fig. 7), und

-daß aus der derart störungsbefreiten Kennzeichnungsbeschreibung Merkmale zur automatischen Kennzeichnungs-Erkennung abzuleiten sind.

2. Verfahren nach Anspruch 1, dadurch gekennzeichnet, daß die Überführung des ursprünglichen Bildes (Fig. 1) in das kontrastarme Bild (Fig. 2) mittels eines Rechteckfilters der Kantenlänge 11 × 11 Bildpunkte (Pixels) durchgeführt wird.

3. Verfahren nach Anspruch 1, dadurch gekennzeichnet, daß die Verfahrensschritte rechnergesteuert sind.

4. Verfahren nach Anspruch 1, dadurch gekennzeichnet , daß das von Helligkeitsschwankungen befreite Bild mittels einer variablen Schwelle in ein Schwarz/Weiß-Bild übergeführt wird, wobei die variable Schwelle in an sich bekanter Weise aus dem Grauwerthistogramm des von Helligkeitsschwankungen befreiten Bildes ermittelt wird.

## FIG 1

Kameraaufnahme einer
Ziffer auf dem
Halbleitersubstrat

## FIG 2

Ergebnis der
Tiefpaßfilterung

## FIG 3

Beseitigung störender
Helligkeitsschwankungen
des Substrathintergrunde
durch Helligkeits=
normierung

## FIG 4

Durch eine feste Bild=
schwelle entsteht aus
FIG 3 dieses
Schwarz/Weißbild

# FIG 5

0° (0)  45° (1)  90° (2)  135° (3)

## FIG 6

Rekonstruktion der
ursprünglichen Muster=
ränder aus der rechner=
intern gespeicherten
Datenstuktur. Die Ränder
werden durch Polygon=
züge approximiert.

## FIG 7

Die aus den Daten=
strukturen rekonstrukturierte
Zifferninformation nach
dem Reinigungsvorgang